# FASCICULE DE BREVET EUROPEEN

(11) **EP 3 881 028 B1**
(45) Date de publication et mention de la délivrance du brevet: **07.06.2023**
(21) Numéro de dépôt: 19820837.3
(22) Date de dépôt: 08.11.2019
(51) Int. Cl.: G01B 11/14, G01D 5/34, H03K 17/78, H03K 17/968

(54) **DETECTEUR DE POSITION, DISPOSITIF DE DETECTION D'OUVERTURE DE PORTE ET PROCÉDÉ ASSOCIÉ**
POSITIONSDETEKTOR, TÜRÖFFNUNGSDETEKTIONSVORRICHTUNG UND ZUGEHÖRIGES VERFAHREN
POSITION DETECTOR, DOOR OPENING DETECTION DEVICE AND ASSOCIATED METHOD

(30) Priorité: 14.11.2018 FR 1860470
(43) Date de publication de la demande: 22.09.2021
(73) Titulaire: IFOTEC, 38500 Voiron (FR); Ridgemount Technologies Limited, Bicester, Oxfordshire OX26 5EL (GB)
(72) Inventeur: PETERS, Christopher, Buckinghamshire HP18 9QY (GB); LIMBERT, Mark, Northamptonshire NN12 7AB (GB); BONOMINI, Pierre, 38500 VOIRON (FR); SILLANS, Christian, 38260 LA FRETTE (FR); BILLET, Gilles, 38500 VOIRON (FR)
(74) Mandataire: Talbot, Alexandre
(86) Numéro de dépôt international: PCT/FR2019/052664
(87) Numéro de publication internationale: WO 2020/099765

(56) Documents cités:
- EP-A2- 2 806 251
- DE-A1- 3 918 640
- DE-A1-102014 221 986

## Description

### Domaine technique de l'invention

L'invention est relative à un détecteur de position d'un objet, à un dispositif de détection d'ouverture d'une porte et un procédé utilisant un tel détecteur ou un tel dispositif de détection.

### État de la technique

Dans de nombreux domaines, il est particulièrement avantageux de connaître la position d'un objet pouvant se déplacer entre deux positions distinctes, par exemple une porte ou une fenêtre qui peut être soit ouverte soit fermée.

Sur une porte, il est connu d'installer un contacteur électrique qui peut être de type capacitif, inductif ou magnétique de manière à distinguer une grandeur électrique qui varie entre une porte ouverte et une portée fermée.

Cette solution est intéressante car elle est bon marché et facile à installer dans le secteur résidentiel où les contraintes techniques sont faibles. Cependant, il apparaît que dans de multiples conditions, une telle configuration de détecteur est très difficile à mettre en oeuvre car elle impose de devoir alimenter électriquement un bâtiment et chacune des portes et fenêtres qui doit être suivie.

Il se pose alors un problème d'alimentation électrique du capteur et de traitement du signal fourni par le capteur jusqu'au poste de contrôle.

Il est également connu d'utiliser des détecteurs de position qui utilisent un signal optique. De manière classique, le capteur possède une source lumineuse alimentée en courant. Le capteur est associé à un détecteur de lumière qui reçoit le signal lumineux en provenance de la source lumineuse. Le détecteur est également alimenté en courant.

Le déplacement de la porte peut être détecté lorsque cela se traduit par un arrêt de la réception du signal lumineux par le détecteur de lumière. De manière classique, le capteur est monté sur la partie mobile alors la source de lumière est montée fixe. L'inverse est également vrai. Enfin, il est possible d'agencer la source lumineuse et le capteur fixement et de sorte que le déplacement de la porte interrompe la réception du signal lumineux.

Là encore, il ressort qu'il est nécessaire d'alimenter en courant la source lumineuse et le capteur associé à chaque porte à suivre.

Une telle solution est inenvisageable lorsque la porte dont la position doit être connue se trouve à grande distance du poste de contrôle et surtout lorsque la porte ne se trouve pas à proximité d'une source de tension.

Une telle solution est inenvisageable lorsqu'un très grand nombre de portes doit être suivi car cela implique une consommation électrique importante pour alimenter les détecteurs quelle que soit la technologie utilisée. Il en est de même lorsque le détecteur doit être installé dans une enceinte confinée telle qu'une enceinte destinée à recevoir des matières explosives ou inflammables.

Le document EP 2806251 traite d'un détecteur de position par fibre optique pour un avion. Le détecteur de position comporte une fibre optique recevant un signal lumineux bidirectionnel et un prisme. Le prisme renvoie le rayon lumineux en direction d'un élément absorbeur de lumière ou d'un élément réflecteur de lumière. Une tige fixée à l'élément à suivre se déplace entre le prisme et l'élément absorbeur de lumière ou l'élément réflecteur de lumière de manière à autoriser ou interdire une réflexion du signal lumineux en provenance du prisme.

### Résumé de l'invention

Un objet de l'invention consiste à prévoir un dispositif de détection passif qui peut être utilisé plus facilement dans des configurations variées.

On tend à résoudre ce besoin au moyen d'un détecteur de position d'un objet comportant :
- un corps définissant une entrée destinée à recevoir une fibre optique délivrant un premier signal lumineux,
- une sortie délivrant un signal représentatif de la position de l'objet à suivre.

Le détecteur de position est remarquable en ce qu'il comporte :
- un miroir monté mobile à l'intérieur du corps et par rapport à l'entrée entre une première position et une deuxième position, la première position ou la deuxième positions assurant la transmission du signal lumineux depuis l'entrée jusqu'à la sortie pour former un signal lumineux représentatif de la position de l'objet, l'autre position parmi la première position et la deuxième position empêchant la transmission du signal lumineux jusqu'à la sortie,
- un premier ressort monté dans le corps et configuré pour placer le miroir dans la première position en l'absence de sollicitation,
- un embout mobile par rapport au corps entre une première position et une deuxième position selon une direction de déplacement et destiné à coopérer avec l'objet à suivre, l'embout étant lié mécaniquement au miroir de sorte que

- lorsque l'embout est dans la première position, le miroir est dans la première position,
- lorsque l'embout est dans la deuxième position, le miroir est dans la deuxième position,
- le déplacement de l'embout depuis la première position jusqu'à la deuxième position entraine le déplacement du miroir depuis la première position jusqu'à la deuxième position.

Dans un développement, le miroir est monté mobile en translation entre la première position et la deuxième position.

Avantageusement, un deuxième ressort est monté sur le miroir et l'embout, le deuxième ressort étant configuré pour déplacer l'embout vers la première position.

Dans un mode de réalisation particulier, le détecteur comporte un système de fixation du corps à un point fixe, le système de fixation comportant deux éléments en saillie entourant le corps, les deux éléments en saillie étant espacés selon une direction reliant l'entrée et l'embout, au moins un des deux éléments en saillie étant monté amovible par rapport au corps.

Il est avantageux de prévoir que l'entrée forme la sortie de sorte que le signal lumineux en sortie du détecteur de position passe par la fibre optique.

Dans un autre développement, le détecteur comporte une butée faisant saillie de l'embout, la butée étant montée réglable de manière à moduler l'extension de la butée par rapport à l'embout selon la direction de déplacement.

L'invention a également pour objet une enceinte munie d'une ouverture qui est fermée par l'objet, l'enceinte comportant le détecteur de position selon l'un des modes de réalisation précédents, le détecteur de position étant agencé de sorte que :
- lorsque l'objet est dans la première position, l'embout est dans la première position,
- lorsque l'objet est dans la deuxième position, l'embout est dans la deuxième position,
- le déplacement de l'objet depuis la première position jusqu'à la deuxième position entraine le déplacement de l'embout depuis la première position jusqu'à la deuxième position.

Préférentiellement, l'enceinte est un noeud de raccordement optique comportant une pluralité de fibres optiques.

L'invention a encore pour objet un procédé de détection de la position d'un objet qui est facile à mettre en oeuvre.

Le procédé de détection est remarquable en ce qu'il comporte les étapes suivantes:
- Fournir un détecteur de position selon l'une quelconque des configurations précédentes,
- Déplacer l'objet depuis la première position jusqu'à la deuxième position causant un déplacement du miroir depuis la première position jusqu'à la deuxième position et causant une modification du signal de sortie

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1 représente une vue schématique de côté d'un détecteur de position d'un objet et d'une fibre optique avant son installation dans le détecteur de position selon un mode de réalisation de l'invention ;
- la figure 2 représente, de manière schématique, en coupe longitudinale, un détecteur de position selon un mode de réalisation de l'invention, l'embout étant dans la première position.

### Description d'un mode de réalisation préféré de l'invention

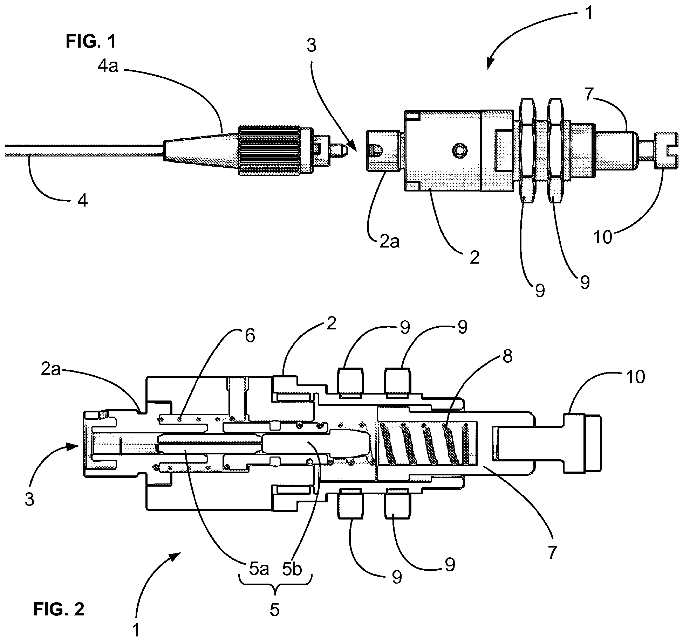

La figure 1 illustre un détecteur de position 1 muni d'un corps 2 définissant une entrée 3 qui va recevoir une fibre optique 4. La fibre optique 4 délivre un signal lumineux qui chemine dans le détecteur de position 1. Le détecteur de position 1 délivre un signal de sortie représentatif de la position d'un l'objet associé. Le signal de sortie est un signal lumineux.

Le corps 2 comporte avantageusement une tête 2a qui coopère avec un organe de couplage 4a monté sur la fibre optique 4.

Le détecteur de position 1 comporte un miroir 5 monté mobile à l'intérieur du corps 2 et par rapport à l'entrée 3. Le miroir 5 se déplace entre une première position et une deuxième position. La première position ou la deuxième positions assure la transmission du signal lumineux depuis l'entrée 3 jusqu'à la sortie pour délivrer un signal représentatif de la position de l'objet. L'autre position parmi la première position et la deuxième position empêche la transmission du signal lumineux jusqu'à la sortie. La position de l'objet est définie par la fourniture ou non d'un signal lumineux.

Avec une telle configuration, la détection ou non d'un signal de sortie présent sur la sortie du détecteur de position 1 permet de déterminer si l'objet à suivre se trouve dans la première position ou dans la deuxième position.

Le miroir 5 se déplace entre deux positions ce qui permet de fournir un signal de sortie qui correspond au signal d'entrée. De cette manière, le détecteur de position 1 peut être dépourvu d'une source lumineuse. Cette configuration permet de déporter la source lumineuse à grande distance et notamment dans une zone qui est alimentée en courant ce qui peut ne pas être le cas de la zone qui comporte le détecteur de position. Le détecteur est avantageusement dépourvu d'un capteur de signal lumineux.

L'utilisation d'un miroir 5 permet de former un dispositif passif qui ne comporte pas de source lumineuse, ni de capteur de lumière ce qui permet son installation sans utiliser de source de courant électrique.

De manière avantageuse, le miroir 5 comporte une ligne de transmission 5a qui vient en contact de la fibre optique 4 et un réflecteur 5b. Le signal lumineux se réfléchit sur le réflecteur 5b depuis la ligne de transmission 5a. Il est avantageux de rendre mobile la ligne de transmission 5a et le réflecteur 5b pour mieux réaliser la transmission ou non du signal de sortie. De manière avantageuse, la ligne de transmission 5a est formée par une fibre optique. Une fibre optique est un fil dont l'âme, très fine, est formée avantageusement en verre ou en plastique et a la propriété de conduire la lumière. L'âme est recouverte par une gaine protectrice.

Un premier ressort 6 est monté dans le corps 2. Le premier ressort 6 est configuré pour placer le miroir 5 dans la première position. En l'absence de sollicitation, le miroir 5 se trouvant dans la deuxième position est ramené vers la première position.

Le détecteur 1 comporte encore un embout 7 mobile par rapport au corps 2 entre une première position et une deuxième position selon une direction de déplacement. L'embout 7 est destiné à coopérer avec l'objet à suivre. L'embout 7 est en saillie du corps 2 et il coulisse avantageusement dans le corps de manière à déplacer le miroir 5.

L'embout 7 est lié mécaniquement au miroir 5 de sorte que :
- lorsque l'embout 7 est dans la première position, le miroir 5 est dans la première position,
- lorsque l'embout 7 est dans la deuxième position, le miroir 5 est dans la deuxième position,
- le déplacement de l'embout 7 depuis la première position jusqu'à la deuxième position entraine le déplacement du miroir 5 depuis la première position jusqu'à la deuxième position.

De manière avantageuse, le miroir 5 est monté mobile uniquement en translation entre la première position et la deuxième position. Le montage uniquement en translation permet la réalisation un détecteur de position 1 qui est compact et facile à réaliser ainsi que plus résistant en comparaison d'une configuration où le miroir 5 est monté rotatif.

Dans le mode de réalisation illustré à la figure 2, un deuxième ressort 8 est monté sur le miroir 5 et l'embout 7. Le deuxième ressort 8 est configuré pour déplacer l'embout 7 vers la première position. Il est particulièrement avantageux de prévoir que le miroir 5 ne soit pas monté directement sur l'embout 7. En effet, lorsque le miroir 5 est fixé directement à l'embout 7, tous les chocs reçus par l'embout 7, par exemple lorsque la porte rencontre violemment l'embout 7, se traduisent par autant de chocs sur le miroir 5 qui peut finir par se détériorer ou venir heurter d'autres composants du détecteur 1 ou la fibre optique 4. Il est alors avantageux d'installer un élément élastique, par exemple un deuxième ressort, qui est monté entre le miroir 5 et l'embout 7. De manière avantageuse, le deuxième ressort est monté dans le corps 2.

Une contrainte appliquée sur l'embout 7 pour le déplacer depuis la première position vers la deuxième position cause l'application d'une contrainte sur le miroir pour le déplacer depuis la première position vers la deuxième position. Le moyen élastique 8 absorbe une partie de la contrainte initiale pour avoir un déplacement du miroir sans que la zone de contact entre la fibre et le miroir soit soumise à des contraintes importantes.

La dureté de l'élément élastique 8 est choisie de manière à ne pas empêcher le déplacement du miroir 5 en absorbant complètement le déplacement de l'embout 7. On évitera d'utiliser un matériau trop mou. Selon la même logique, on évitera d'utiliser un matériau trop rigide dont la déformation sera nulle ou faible ce qui aboutit à la configuration sans l'élément élastique 8.

Les premier et deuxième ressorts 6 et 8 sont agencés de manière à appliquer des forces antagonistes sur le miroir 5. Cependant, il est particulièrement avantageux que la force exercée par le deuxième ressort 8 soit supérieure à la force exercée par le premier ressort 6 afin d'éloigner le miroir 5 de la fibre optique 4 et ainsi détecter plus facilement par exemple une ouverture de la porte. Lorsque l'embout 7 se déplace, l'utilisation d'un ressort 8 ayant une raideur supérieure à la raideur du ressort 6 permet de rapprocher le miroir 5 de la fibre 4 et de le placer dans une position de réflexion, de préférence une position de réflexion optimale. Une fois le miroir 5 en contact avec la fibre 4, la surcourse de l'embout 7 ou de tout élément à suivre est absorbée par les ressorts pour éviter d'appliquer une contrainte trop importante à l'interface entre le miroir 5 et la fibre 4 et ainsi ne pas user prématurément le miroir 5.

Il est avantageux d'avoir un élément élastique 8 dont la raideur est dans la même gamme que celle du premier ressort 6. De préférence, le deuxième ressort 8 est moins de dix fois plus raide que le premier ressort 6, encore plus préférentiellement moins de cinq fois plus raide et de manière encore plus préférentielle moins de deux fois plus raide.

De manière avantageuse, le premier ressort 6 et l'élément élastique 8 sont séparés par le miroir 5.

Préférentiellement, en l'absence de sollicitation, le premier ressort 6 déplace le miroir 5 dans une position où le signal lumineux fourni à l'entrée 3 n'atteint pas la sortie. Selon l'invention, lorsque la fibre optique 4 est installée dans l'entrée 3, le miroir 5 arrive en butée contre la fibre optique et non contre une autre butée du détecteur lorsque le miroir est dans la deuxième position.

En d'autres termes, en l'absence de sollicitation, le premier ressort 6 déplace le miroir 5 à distance de la fibre optique 4 de sorte que lors du déplacement de l'embout 7 de la première position à la deuxième position, le miroir 5 se déplace de la première position jusqu'à la deuxième position qui est définie par le contact entre le miroir 5 et la fibre optique 4. Cette configuration permet une meilleure adaptabilité de la deuxième position à l'enfoncement de la fibre optique 4 dans le détecteur 1.

Il convient également de remarquer que le miroir 5 ne force pas contre la fibre optique 4, la force appliquée sur la fibre optique 4 est définie par la raideur du deuxième ressort 8.

Dans le mode de réalisation illustré, le miroir 5 est agencé de sorte que l'entrée 3 recevant le signal lumineux de la fibre optique 4 renvoie le signal vers l'entrée qui forme ainsi la sortie. En d'autres termes, le miroir 5 est agencé pour renvoyer le signal de sortie dans la fibre optique 4.

Le plan réfléchissant du miroir 5 est agencé perpendiculaire à l'axe longitudinal de la fibre optique 4 ou sensiblement perpendiculaire à l'axe longitudinal de la fibre optique 4. De manière avantageuse, le contact entre la ligne de transmission 5a et la fibre optique 4 est de type APC (Angled Physical Contact). Préférentiellement, la fibre optique 4 et la ligne de transmission 5a possèdent chacune une face qui n'est pas perpendiculaire à l'axe longitudinal de la fibre optique 4. De manière avantageuse, le décalage angulaire entre le plan terminal de la fibre optique 4 et de la ligne de transmission 5a est décalé d'un angle compris entre 5° à 12° par rapport au plan perpendiculaire à l'axe longitudinal de la fibre optique 4. Ainsi, les déviations conjuguées des faisceaux incidents et réfléchis permettent d'augmenter très vite l'atténuation en fonction de l'écartement des faces de la fibre 4 et de l'élément de transmission 5a. Cette atténuation provoque la divergence des faisceaux incident et réfléchissant, la réflexion de Fresnel inhérente à la fibre 4 étant non conduite dans la fibre grâce à l'angle de la face.

Dans certains modes de réalisation, le signal réfléchi par le miroir 5 peut être encore plus atténué par une rotation du miroir 5 par rapport à la fibre optique 4 combinée au déplacement longitudinal du miroir 5 ou/et par un traitement anti-réfléchissant des parois de chambre contenant le miroir 5.

Il est encore envisageable de prévoir un mode de réalisation particulier dans lequel des lentilles munies de traitements anti-réfléchissants sont insérées pour réaliser la même fonction sans contact. Préférentiellement, les lentilles sont configurées pour former des faisceaux expansés, les lentilles se déplaçant en fonction de la position de l'embout 7 ce qui modifie la forme du faisceau pour discriminer au moins deux positions de l'embout 7.

L'utilisation de la fibre optique 4 pour recevoir le signal optique de sortie permet d'augmenter la compacité du détecteur 1. L'autre extrémité de la fibre optique est munie d'un dispositif qui génère un signal lumineux et qui est également capable de détecter le signal lumineux qui provient de la fibre optique 4. Ainsi, un utilisateur disposé à l'autre extrémité de la fibre optique 4 émet un signal lumineux qui atteint le détecteur de position 1. Selon la position de l'embout 7 un signal lumineux est renvoyé en sortie ou non ce qui permet à l'utilisateur de connaître la position de l'embout 7 et donc la position de l'objet coopérant avec l'embout 7.

Le détecteur de position 1 délivre un signal de sortie représentatif de la position de l'embout 7 qui coopère avec un objet à suivre par exemple une porte, une fenêtre ou tout autre objet pouvant fermer une ouverture. De manière préférentielle, le détecteur de position 1 est monté fixe et l'objet se déplace ce qui cause le déplacement de l'embout. En alternative, le détecteur est monté sur l'objet mobile et l'embout 7 coopère avec l'élément fixe. Il est également possible de prévoir que l'objet à suivre soit mobile et que le détecteur de position soit également monté sur un élément mobile.

Afin de faciliter son installation, le détecteur 1 comporte avantageusement un système de fixation du corps 2 à un organe d'accrochage. Le système de fixation comporte deux éléments 9 en saillie entourant le corps 2. Les deux éléments 9 en saillie sont espacés selon une direction reliant l'entrée 3 et l'embout 7. Au moins un des deux éléments 9 en saillie est monté amovible par rapport au corps 2.

L'installation du détecteur 1 s'effectue en insérant le détecteur dans un trou traversant supérieur à la dimension du corps 2 et inférieur à la dimension des deux éléments en saillie 9. Le serrage des deux éléments 9 en saillie permet d'installer fixement le détecteur 1 dont l'embout 7 va coopérer avec l'objet dont la position doit être suivie.

De manière avantageuse, un des éléments 9 ou les deux éléments 9 en saillie sont vissés sur le corps 2 pour moduler la distance entre les deux éléments en saillie 9 ainsi que la force de serrage du détecteur sur son support.

De manière avantageuse, le détecteur 1 comporte une butée 10 montée sur l'embout 7. La butée 10 fait saillie de l'embout 7 de manière à ce que la butée 10 vienne en contact de l'objet à suivre. La butée 10 est configurée pour s'étendre plus ou moins depuis la surface de l'embout 7 de manière à adapter l'enfoncement de l'embout 7 dans le corps 2 lors du déplacement de l'objet. A titre d'exemple, la butée est montée rotative sur un pas de vis pour régler l'extension de la butée 10 par rapport à l'embout 7.

Un tel détecteur de position 1 est particulièrement avantageux pour suivre les ouvertures de porte, de fenêtre et/ou de tout orifice telle qu'une trappe d'accès ou une trappe de visite dans une enceinte qui n'est pas alimentée en courant électrique. Il est envisagé d'installer le détecteur de position sur un couvercle de bouche d'égout, ou sur une porte d'un navire submersible ou insubmersible. Il ressort qu'il est particulièrement compliqué de réaliser des trous dans la paroi d'un navire. Il est donc particulièrement avantageux d'utiliser cette technologie qui évite de repercer la paroi d'un navire.

Il est particulièrement avantageux d'utiliser un tel détecteur dans un noeud de raccordement optique qui possède plusieurs fibres optiques et qui est souvent dépourvu de courant électrique.

Un tel détecteur est également particulièrement avantageux pour suivre l'ouverture et la fermeture d'une enceinte destinée à recevoir des matières explosives et/ou inflammables et pour laquelle l'emploi d'un détecteur alimenté en courant est proscrit ou beaucoup plus difficile à mettre en oeuvre.

Un tel détecteur est également particulièrement avantageux pour suivre l'ouverture et la fermeture d'une porte, fenêtre ou trappe qui se trouve dans un milieu humide ou submersible.

Dans le mode de réalisation illustré, le détecteur est passif, c'est-à-dire qu'il est dépourvu d'alimentation électrique. Le détecteur est raccordé à une fibre optique 4 qui fournit un signal lumineux. Ce même signal lumineux est réémis ou non dans la fibre optique ce qui permet de discriminer la position de l'embout 7.

L'utilisation d'une fibre optique 4 associée à un signal lumineux est particulièrement avantageuse car la source de lumière peut être distante de plusieurs centaines de mètres voire dizaines de kilomètres du détecteur, par exemple supérieure à 10 kilomètres.

Il ressort également que le signal indiquant la position de l'embout et donc la position de l'objet à suivre est un signal optique ce qui permet de gérer facilement un très grand nombre d'objets en multiplexant les différents signaux provenant de multiples détecteurs.

Le fonctionnement du détecteur peut être présenté de la manière suivante. Le détecteur utilisé est un détecteur conforme à l'un des différents modes de réalisation présentés plus haut.

L'objet est déplacé depuis la première position jusqu'à la deuxième position ce qui cause un déplacement de l'embout 7 depuis la première position jusqu'à la deuxième position et donc un déplacement du miroir 5 depuis la première position jusqu'à la deuxième position. Le déplacement du miroir 5 cause une modification du signal de sortie. Le signal de sortie sous forme lumineuse peut s'éteindre à cause du déplacement. En alternative, le signal lumineux peut apparaître à cause du déplacement.

Comme indiqué plus haut lorsque l'objet se déplace depuis la deuxième position jusqu'à la première position, l'embout se déplace également depuis la deuxième position jusqu'à la première position tout comme le miroir. Le signal de sortie change d'état.

A titre d'exemple, dans une intervention, une enceinte est ouverte ce qui modifie l'état du signal de sortie délivré par le détecteur 1. Le changement d'état peut être associé à un repère temporel. Une fois l'intervention terminée, l'enceinte est refermée ce qui modifie l'état du signal de sortie délivré par le détecteur 1. Le changement d'état peut être associé à un repère temporel. La durée d'intervention correspond à la durée séparant les deux changements d'état. Cela permet de connaître précisément la durée de l'intervention. Cela permet également de détecter si l'enceinte n'a pas été correctement refermée.

Le détecteur n'étant pas alimenté en courant électrique et étant muni d'un miroir mobile installé dans le corps, cela en fait un détecteur robuste.

De manière avantageuse, lorsque l'objet est dans sa position attendue, par exemple la porte, la fenêtre et d'une manière générale l'orifice est fermé, le détecteur émet un signal lumineux de sortie. L'absence de signal lumineux traduit alors l'ouverture de l'orifice ou un mauvais fonctionnement du détecteur ou de la source lumineuse.

De manière avantageuse, le détecteur de position 1 est étanche à la poussière ou aux liquides une fois que la fibre optique 4 est installée dans le corps 2.

## Revendications

1. Détecteur de position (1) d'un objet comportant :
- un corps (2) définissant une entrée (3) destinée à recevoir une fibre optique (4) délivrant un premier signal lumineux,
- une sortie délivrant un signal représentatif de la position de l'objet à suivre,
détecteur de position (1) **caractérisé en ce qu'**il comporte :
- un miroir (5) monté mobile à l'intérieur du corps (2) et par rapport à l'entrée (3) entre une première position et une deuxième position, la première position ou la deuxième position assurant la transmission du signal lumineux depuis l'entrée (3) jusqu'à la sortie pour former un signal lumineux représentatif de la position de l'objet, l'autre position parmi la première position et la deuxième position empêchant la transmission du signal lumineux jusqu'à la sortie,
- un premier ressort (6) monté dans le corps (2) et configuré pour placer le miroir (5) dans la première position,
- un embout (7) mobile par rapport au corps (2) entre une première position et une deuxième position selon une direction de déplacement et destiné à coopérer avec l'objet à suivre, l'embout (7) étant lié mécaniquement au miroir (5) de sorte que :
- lorsque l'embout (7) est dans la première position, le miroir (5) est dans la première position,
- lorsque l'embout (7) est dans la deuxième position, le miroir (5) est dans la deuxième position,
- le déplacement de l'embout (7) depuis la première position jusqu'à la deuxième position entraine le déplacement du miroir (5) depuis la première position jusqu'à la deuxième position, de manière à ce que le miroir (5) arrive en butée contre la fibre optique (4) dans la position assurant la transmission du signal lumineux.

2. Détecteur de position (1) selon la revendication 1 dans lequel le miroir (5) est monté mobile en translation entre la première position et la deuxième position.

3. Détecteur de position (1) selon l'une des revendications précédentes dans lequel un deuxième ressort (8) est monté sur le miroir (5) et l'embout (7), le deuxième ressort (8) étant configuré pour déplacer l'embout (7) vers la première position.

4. Détecteur de position (1) selon l'une quelconque des revendications précédentes comportant un système de fixation du corps (2) à un organe d'accrochage, le système de fixation comportant deux éléments (9) en saillie entourant le corps (2), les deux éléments (9) en saillie étant espacés selon une direction reliant l'entrée (3) et l'embout (7), au moins un des deux éléments (9) en saillie étant monté amovible par rapport au corps (2).

5. Détecteur de position (1) selon l'une quelconque des revendications précédentes dans lequel l'entrée (3) forme la sortie de sorte que le signal lumineux en sortie de l'interrupteur optique (1) passe par la fibre optique (4).

6. Détecteur de position (1) selon l'une quelconque des revendications précédentes comportant une butée (10) faisant saillie de l'embout (7), la butée (10) étant montée réglable de manière à moduler l'extension de la butée (10) par rapport à l'embout (7) selon la direction de déplacement.

7. Enceinte comportant l'objet et le détecteur de position (1) selon l'une quelconque des revendications précédentes, le détecteur de position (1) étant agencé de sorte que :
- lorsque l'objet est dans la première position, l'embout (7) est dans la première position,
- lorsque l'objet est dans la deuxième position, l'embout (7) est dans la deuxième position,
- le déplacement de l'objet depuis la première position jusqu'à la deuxième position entraine le déplacement de l'embout (7) depuis la première position jusqu'à la deuxième position.

8. Enceinte selon la revendication précédente dans laquelle l'objet est une porte, une fenêtre ou une trappe.

9. Enceinte selon la revendication précédente dans laquelle l'enceinte est un noeud de raccordement optique comportant une pluralité de fibres optiques.

10. Procédé de détection de la position d'un objet, comportant les étapes suivantes :
- Fournir un détecteur de position (1) selon l'une quelconque des revendications 1 à 6,
- Déplacer l'objet depuis la première position jusqu'à la deuxième position causant un déplacement du miroir (5) depuis la première position jusqu'à la deuxième position et causant une modification du signal de sortie.

## Patentansprüche

1. Positionsdetektor (1) für ein Objekt, umfassend:
- einen Körper (2), der einen Eingang (3) zur Aufnahme eines Lichtwellenleiters (4) definiert, der ein erstes Lichtsignal ausgibt,
- einen Ausgang, der ein Signal ausgibt, das für die Position des zu verfolgenden Objekts repräsentativ ist,
wobei der Positionsdetektor (1) **dadurch gekennzeichnet ist, dass** er umfasst:
- einen Spiegel (5), der innerhalb des Körpers (2) und in Bezug auf den Eingang (3) zwischen einer ersten Position und einer zweiten Position beweglich montiert ist, wobei die erste Position oder die zweite Position die Übertragung des Lichtsignals vom Eingang (3) zum Ausgang gewährleistet, um ein Lichtsignal zu bilden, das für die Position des Objekts repräsentativ ist, wobei die andere von der ersten Position und der zweiten Position die Übertragung des Lichtsignals zum Ausgang verhindert,
- eine erste Feder (6), die im Körper (2) montiert und dazu konfiguriert ist, den Spiegel (5) in die erste Position zu bringen,
- einen Ansatz (7), der in Bezug auf den Körper (2) entlang einer Bewegungsrichtung zwischen einer ersten Position und einer zweiten Position beweglich ist und dazu bestimmt ist, mit dem zu verfolgenden Objekt zusammenzuwirken, wobei der Ansatz (7) mechanisch derart mit dem Spiegel (5) verbunden ist, dass:
- der Spiegel (5) in der ersten Position ist, wenn der Ansatz (7) in der ersten Position ist,
- der Spiegel (5) in der zweiten Position ist, wenn der Ansatz (7) in der zweiten Position ist,
- die Bewegung des Ansatzes (7) von der ersten Position in die zweite Position die Bewegung des Spiegels (5) von der ersten Position in die zweite Position bewirkt, wodurch der Spiegel (5) in der Position, die die Übertragung des Lichtsignals gewährleistet, mit dem Lichtwellenleiter (4) in Anlage kommt.

2. Positionsdetektor (1) nach Anspruch 1, wobei der Spiegel (5) zwischen der ersten Position und der zweiten Position translationsbeweglich montiert ist.

3. Positionsdetektor (1) nach einem der vorherigen Ansprüche, wobei eine zweite Feder (8) am Spiegel (5) und am Ansatz (7) angebracht ist, wobei die zweite Feder (8) dazu konfiguriert ist, den Ansatz (7) zur ersten Position hin zu bewegen.

4. Positionsdetektor (1) nach einem der vorherigen Ansprüche, umfassend ein System zur Befestigung des Körpers (2) an einem Einhängeorgan, wobei das Befestigungssystem zwei vorstehende Elemente (9) aufweist, die den Körper (2) umgeben, wobei die zwei vorstehenden Elemente (9) in einer Richtung beabstandet sind, die den Eingang (3) und den Ansatz (7) verbindet, wobei mindestens eines der zwei vorstehenden Elemente (9) in Bezug auf den Körper (2) abnehmbar montiert ist.

5. Positionsdetektor (1) nach einem der vorherigen Ansprüche, wobei der Eingang (3) den Ausgang bildet, sodass das Lichtsignal am Ausgang des optischen Schalters (1) den Lichtwellenleiter (4) durchläuft.

6. Positionsdetektor (1) nach einem der vorherigen Ansprüche, umfassend einen Anschlag (10), der vom Ansatz (7) vorspringt, wobei der Anschlag (10) einstellbar montiert ist, um die Ausdehnung des Anschlags (10) in Bezug auf den Ansatz (7) entlang der Bewegungsrichtung zu modulieren.

7. Abgeschlossener Bereich, umfassend das Objekt und den Positionsdetektor (1) nach einem der vorherigen Ansprüche, wobei der Positionsdetektor (1) derart angeordnet ist, dass :
- der Ansatz (7) in der ersten Position ist, wenn das Objekt in der ersten Position ist,
- der Ansatz (7) in der zweiten Position ist, wenn das Objekt in der zweiten Position ist,
- die Bewegung des Objekts von der ersten Position in die zweite Position bewirkt, dass der Ansatz (7) sich von der ersten Position in die zweite Position bewegt.

8. Abgeschlossener Bereich nach dem vorherigen Anspruch, wobei das Objekt eine Tür, ein Fenster oder eine Falltür ist.

9. Abgeschlossener Bereich nach dem vorherigen Anspruch, wobei der abgeschlossene Bereich ein optischer Verbindungsknoten ist, der eine Vielzahl von Lichtwellenleitern umfasst.

10. Verfahren zur Detektion der Position eines Objekts, umfassend die folgenden Schritte:
- Bereitstellen eines Positionsdetektors (1) nach einem der Ansprüche 1 bis 6,
- Bewegen des Objekts von der ersten Position in die zweite Position, um eine Bewegung des Spiegels (5) von der ersten Position in die zweite Position zu bewirken und eine Änderung des Ausgabesignals zu bewirken.

## Claims

1. Position detector (1) of an object comprising:
- a body (2) defining an input (3) designed to receive an optical fiber (4) delivering a first light signal,
- an output delivering a signal representative of the position of the object to be monitored,
position detector (1) **characterized in that** it comprises:
- a mirror (5) mounted so as to be movable inside the body (2) and relative to the input (3) between a first position and a second position, the first position or the second position ensuring the transmission of the light signal from the input (3) to the output to form a light signal representative of the position of the object, the other position among the first position and the second position preventing the transmission of the light signal to the output,
- a first spring (6) mounted in the body (2) and configured to place the mirror (5) in the first position,
- an end piece (7) movable relative to the body (2) between a first position and a second position along a direction of movement and designed to cooperate with the object to be monitored, the end piece (7) being mechanically connected to the mirror (5) so that:
- when the end piece (7) is in the first position, the mirror (5) is in the first position,
- when the end piece (7) is in the second position, the mirror (5) is in the second position,
- displacement of the end piece (7) from the first position to the second position causes the mirror (5) to move from the first position to the second position, so that the mirror (5) comes to rest against the optical fiber (4) in the position ensuring the transmission of the light signal.

2. Position detector (1) according to claim 1 wherein the mirror (5) is mounted for translational movement between the first position and the second position.

3. Position detector (1) according to any of the preceding claims wherein a second spring (8) is mounted on the mirror (5) and the end piece (7), the second spring (8) being configured to move the end piece (7) towards the first position.

4. Position sensor (1) according to any one of the preceding claims comprising a system for fixing the body (2) to a hooking member, the system for fixing comprising two protruding elements (9) surrounding the body (2), the two protruding elements (9) being spaced apart along a direction connecting the inlet (3) and the end piece (7), at least one of the two protruding elements (9) being mounted removable with respect to the body (2)

5. Position detector (1) according to any of the preceding claims wherein the input (3) forms the output so that the light signal output from the position detector (1) passes through the optical fiber (4).

6. Position detector (1) according to any one of the preceding claims comprising a stop (10) projecting from the end piece (7), the stop (10) being mounted adjustable so as to modulate the extension of the stop (10) relative to the end piece (7) according to the direction of movement.

7. Enclosure comprising the object and the position detector (1) according to any of the preceding claims, the position detector (1) being arranged so that:
- when the object is in the first position, the end piece (7) is in the first position,
- when the object is in the second position, the end piece (7) is in the second position,
- movement of the object from the first position to the second position causes movement of the end piece (7) from the first position to the second position.

8. Enclosure according to the preceding claim wherein the object is a door, a window or a hatch.

9. Enclosure according to the preceding claim wherein the enclosure is an optical connection node comprising a plurality of optical fibers.

10. Method for detecting the position of an object, comprising the following steps:
- providing a position detector (1) according to any one of claims 1 to 6,
- moving the object from the first position to the second position causing the mirror (5) to move from the first position to the second position and causing the output signal to change.
